# EUROPEAN PATENT SPECIFICATION

(11) **EP 2 153 699 B1**
(45) Date of publication and mention of the grant of the patent: **13.07.2016**
(21) Application number: 08728221.6
(22) Date of filing: 24.01.2008
(51) Int. Cl.: H01L 51/52, H05B 33/02, H05B 33/10

(54) **ORGANIC ELECTRONIC DEVICES PROTECTED BY ELASTOMERIC LAMINATING ADHESIVE**
DURCH EINEN ELASTOMEREN LAMINIERUNGSHAFTSTOFF GESCHÜTZTE ORGANISCHE ELEKTRONISCHE BAUELEMENTE
DISPOSITIFS ÉLECTRONIQUES ORGANIQUES PROTÉGÉS PAR UN ADHÉSIF DE STRATIFICATION ÉLASTOMÉRIQUE

(30) Priority: 18.05.2007 US 938841 P
(43) Date of publication of application: 17.02.2010
(73) Proprietor: Henkel AG & Co. KGaA, 40589 Düsseldorf (DE)
(72) Inventor: CAO, Jie, Hillsborough, NJ 08844 (US)
(86) International application number: PCT/US2008/051921
(87) International publication number: WO 2008/144080

(56) References cited:
- WO-A1-2006/107748
- WO-A1-2007/087157
- WO-A1-2007/111607
- JP-A- 05 182 759
- JP-A- 08 236 271
- JP-A- 2001 068 266
- US-A1- 2003 203 210
- US-A1- 2005 093 439
- US-A1- 2005 227 114
- US-A1- 2007 013 292
- US-B2- 7 063 902

## Description

### FIELD OF THE INVENTION

This invention relates to active organic components within an organic electronic device, the components protected from environmental elements by an elastomeric laminating adhesive.

### BACKGROUND OF THE INVENTION

Organic electronic devices and circuits, such as, organic light emitting diodes, organic electrophoretic displays, organic electrochromic displays, and organic photovoltaic devices, are becoming increasingly prevalent in social and commercial uses. Organic light emitting devices (OLEDs), for example, have utility in virtual- and direct-view displays, such as, lap-top computers, televisions, digital watches, telephones, pagers, cellular telephones, calculators, large-area devices, and the like.

Various package geometries are known in the art for organic electronic devices and circuits, and in general, these geometries consist of an active organic component, such as, a light emitting diode, disposed between a substrate and a cover, the substrate and cover adhered together with an adhesive that encloses the active organic component. One or both of the cover and substrate are made of a transparent material, for example, transparent glass or plastic. The substrate and cover are sometimes flexible, and in addition to glass or plastic, one or the other may be composed of steel. The active organic component is attached to the substrate, and in some embodiments is covered with an inorganic barrier coating, or a coating composed of a combination or inorganic and organic layers, that seals the surface and perimeter of the contact area between the component and the substrate. An adhesive is applied over the active component, and over the inorganic barrier coating or the coating composed of a combination of inorganic and organic layers, when present. This adhesive fills the space between the substrate and the cover, enclosing the active organic component and adheres the substrate to the cover. In some embodiments, a desiccant package, in the form of a pouch, or a thin or thick film, is attached to the cover, usually in an indentation or cavity in the cover, or alternatively, the desiccant is provided in grooves within the cover.

The various organic components are susceptible to degradation by oxygen and moisture. For example, an OLED, simply described, consists of an anode, a light emitting layer, and a cathode. A layer of low work function metal is typically utilized as the cathode to ensure efficient electron injection and low operating voltages. Low work function metals are chemically reactive with oxygen and moisture, and such reactions will limit the lifetime of the devices. Oxygen and moisture will also react with the light emitting organic materials and inhibit light emission. Therefore, the package surrounding the active organic component is designed to restrict transmission of oxygen and water vapor from the environment to the active organic component.

UV-curable pressure sensitive adhesives can be used for this purpose and typically are provided between two carrier films. Upon removal of one of the carrier films, the exposed adhesive, being pressure sensitive, is attached to either the cover or the substrate by simple contact and the application of pressure. Subsequently, the second carrier film is removed, allowing the cover and the substrate to be attached to one another. If needed, curing is completed by the application of ultraviolet-radiation or heat. These compounds are improvements over epoxies with regard to flexibility, but pressure sensitive adhesives tend to creep upon long term exposure to strain, and this can manifest itself as delamination failure of the display when it is bent (flexible & conformable displays) or held vertical (rigid displays) for long periods. Moreover, manufacturing throughput would be facilitated if the adhesive were in liquid form rather than film form as film adhesives require the use, removal, and disposal of liners.

WO2007/111607 relates to a radiation curable adhesive sealant composition comprising a radiation curable rubber resin not containing siloxane functionality, a radiation curable resin diluent, a photoinitiating system comprising one or more photoinitiators or photosensitizers and optionally one or more inorganic or organic fillers. Adhesive sealants of '607 are suitable for electronic and optoelectronic devices, such as organic light emitting diodes.

WO2007/087157 relates to a method of encapsulating an OLED device. Adhesive material used in the method of '157 may be UV or heat cured epoxy resin, acrylates or pressure sensitive adhesives.

US2007/0013292 relates to a method of fabricating an organic electroluminescent apparatus. Sealing material used in the method of '292 may be UV cured epoxy resin.

US2005/0227114 relates to a water-absorbing agent for an organic EL device comprising an UV rays-curing agent and water-absorbing substance.

US2003/0203210 relates to a multi-layer barrier coating a flexible substrate, wherein said multi-layer barrier coating comprises alternating polymer and inorganic layers.

WO2006/107748 relates to a radiation-curable dessicant-filled adhesive/sealant composition comprising a radiation curable resin, one or more desiccant filler, one or more photoinitiators or photosensitizers and optionally one or more inorganic or organic fillers.

In addition, pressure sensitive adhesives typically have higher viscosity at room temperature than liquid adhesives. Upon the application of a pressure sensitive adhesive to a substrate at room temperature, only poor wet out of the substrate is achieved, which in turn can cause air to be trapped between the adhesive and the substrate. In order to obtain better wet out and minimize the presence of trapped air, hot lamination is used with pressure sensitive adhesives. Sometimes, the heated temperatures exceed 100°C and special equipment is required.

### SUMMARY OF THE INVENTION

This invention is an organic electronic device in which an elastomeric laminating adhesive is used to adhere the substrate and cover of an electronic device and enclose and protect the active organic component within the device. Specifically, this invention relates to an organic electronic device as set out in claim 1.

US 2005/0093439 relates to an organic electroluminescent device comprising an adhesive layer composed of a resin adhesive that is used to real off the electroluminescent units. A solution extracted from the resin adhesive has a pH of not less than four.

The elastomeric laminating adhesive is prepared from a reactive liquid oligomer or polymer, a liquid monomer reactive with the liquid oligomer or polymer. The laminating adhesive may be thermally curable or curable by actinic radiation, and will contain an appropriate initiator for the method of cure.

Liquid laminating adhesives that cure to become elastomeric are advantageously used in these applications as they can be designed to be liquid before cure, which allows them to easily wet out the substrate and to be processed at room temperature without the addition of any heat. The use of a liquid adhesive and the processing at room temperature permits devices to be assembled with low cost equipment, with minimal pressure and stress placed on the optoelectronic device, and with high throughput. After cure, the laminating adhesives form elastomeric networks, which maintain good adhesion, do not exhibit creep/flow, and absorb stress. These adhesives are particularly suitable for application over the whole active organic component and substrate area. In addition, cured elastomeric laminating adhesives can be transparent and suitable for top-emission organic electronic devices.

In another embodiment, this invention is a method for making an organic electronic device as set out in claim 4.

### BRIEF DESCRIPTION OF THE DRAWINGS

FIGURE 1 is a schematic view of an electronic device using a laminating adhesive.
FIGURE 2 is a schematic view of an electronic device using a laminating adhesive, in which the active organic component is protected by a barrier coating
FIGURE 3 is a schematic view of an electronic device using a laminating adhesive. The active organic component is protected by a perimeter sealant and desiccant (as an option).

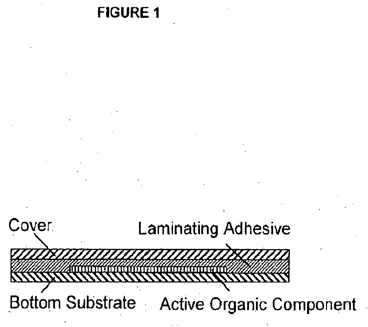

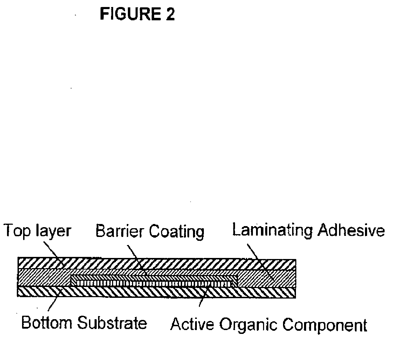

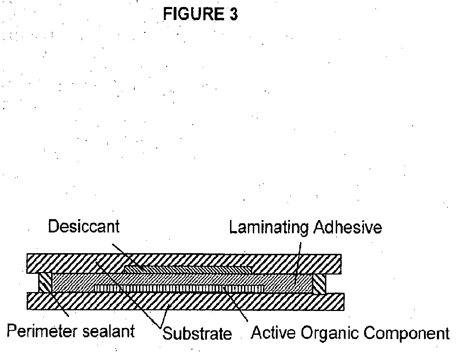

Figures 1, 2, and 3 are simplified representations presented for purposes of illustration only. The actual structures will differ in various aspects, including the relative scale of the components.

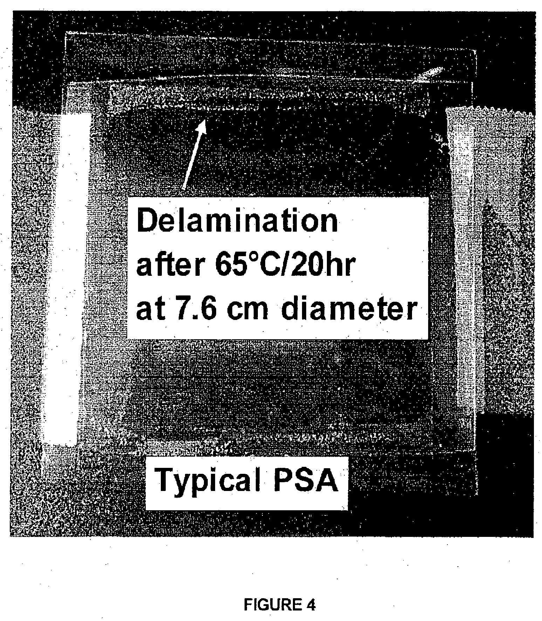

FIGURE 4 is a photograph of the delamination that occurs as a result of creep when a pressure sensitive adhesive is used as a laminating adhesive.

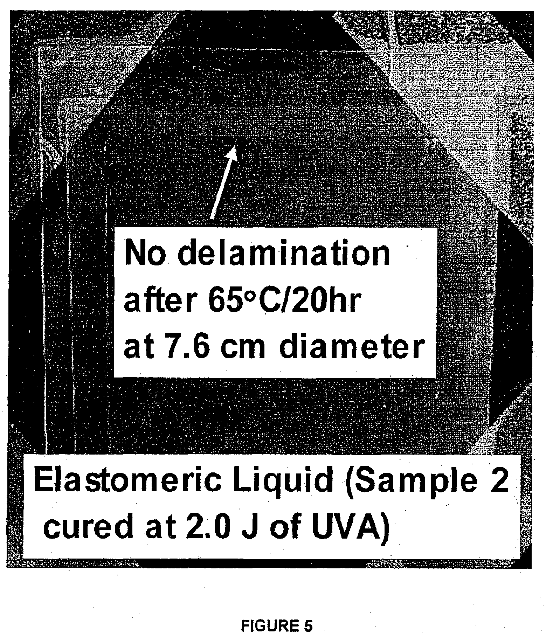

FIGURE 5 is a photograph showing no delamination when an elastomeric laminating adhesive is used.
These Figures are simplified representations presented for purposes of illustration only. The actual structures will differ in various aspects, including the relative scale of the components.

### DETAILED DESCRIPTION OF THE INVENTION

This invention may be embodied in different forms; for example, the active organic component may be an organic light emitter or an organic photovoltaic, or some other type of organic electronic material. The embodiments of the present invention are thus applicable to any organic electronic device having an elastomeric laminating adhesive disposed between the substrate and cover of the device and enclosing an active organic component.

The laminating adhesive is a neat liquid, 100% solids, and is applied by coating or printing, for example, by curtain coating, spray coating, roll coating, stencil printing, screen printing, and other such coating and printing methods known in the art. The laminating adhesive comprises a reactive liquid oligomer and/or polymer, a liquid monomer reactive with the liquid oligomer or polymer, and an initiator, which laminating adhesive cures to become elastomeric. The initiator can be either a free-radical thermal initiator or photoinitiator. Reactive in this sense means the compounds react to form a covalent bond. The laminating adhesive may further comprise an antioxidant and/or other additives commonly added to adhesive compositions.

Exemplary reactive liquid oligomers and/or polymers include (meth)acrylated-polybutadienes, (meth)acrylated-polyisoprenes, (meth)acrylated-polyurethanes, (meth)acrylated urethane oligomers, and (meth)acrylated-polyesters, all of which are available from Sartomer and Kuraray. "(Meth)acrylated" means functionalized with either acrylate or methacrylate. In other embodiments, the reactive liquid oligomers and/or polymers that are (meth)acrylated may include, but are not limited to, (meth)acrylated styrene-butadiene copolymer, (meth)acrylated acrylonitrile-butadiene copolymer, (meth)acrylated polyisobutylene, (meth)acrylated polysiloxanes, (meth)acrylated EPDM rubber (ethylene propylene diene copolymer), (meth)acrylated butyl rubber, (meth)acrylated bromobutyl rubber (bromoisobutylene-isoprene copolymer), (meth)acrylated chlorobutyl rubber (chloroisobutylene-isoprene copolymer. These resins are commercially available without the (meth)acrylate functionality and can be functionalized without undue experimentation by those skilled in the art.

The liquid monomer reactive with the liquid polymer and/or oligomer is an acrylate or methacrylate, and is not particularly limited as long as it is curable by the radical polymerization initiator. Exemplary liquid monomers include butyl (meth)acrylate, cyclohexanedimethylol di(meth)acrylate, dicyclopentenyl (meth)acrylate, dicyclopentadienedimethylol di(meth)acrylate, 2-ethylhexyl (meth)acrylate, hexanediol di(meth)acrylate, 2-hydroxypropyl (meth)acrylate, isobornyl (meth)acrylate, isostearyl acrylate, morpholine (meth)acrylate, nonanediol di(meth)acrylate, phenoxyethyl acrylate, tricyclodecanedimethanol di(meth)acrylate, trimethylolpropane tri(meth)acrylate, tris(2-hydroxyethyl)isocyanurate tri(meth)acrylate. "(Meth)acrylate" means both methacrylate and acrylate. These (meth)acrylates may be used singly or in combination of two or more kinds. Such resins are commercially available from Sartomer and UCB Chemicals.

The radical polymerization initiator for the curable composition is a radical photopolymerization initiator that generates radicals by being decomposed by electromagnetic energy rays such as UV rays, or a thermally decomposable radical polymerization initiator that generates radicals by being thermally decomposed. The radical photopolymerization initiators include Type I alpha cleavage initiators such as acetophenone derivatives such as 2-hydroxy-2-methylpropiophenone and 1-hydroxycyclohexyl phenyl ketone; acylphosphine oxide derivatives such as bis(2,4,6-trimethylbenzoyl) phenylphosphine oxide; and benzoin ether derivatives such as benzoin methyl ether and benzoin ethyl ether. Representative commercially available radical photoinitiators are exemplified by compounds such as IRGACURE 651, IRGACURE 184, IRGACURE 907, DAROCUR 1173 and IRGACURE 819 from Ciba Speciality Chemical. Type II photointiators are also useable, and are exemplified by compounds such as benzophenone, isopropylthioxanthone, and anthroquinone. Many substituted derivatives of these base compounds may also be used. The thermally decomposable radical polymerization initiators include peroxides, such as, 1,1,3,3-tetramethylbutyl peroxy-2-ethyl-hexanoate, 1,1-bis (t-butylperoxy) cyclohexane, 1,1-bis(t-butylperoxy)cyclo-dodecane, di-t-butyl peroxyisophthalate, t-butyl peroxybenzoate, dicumyl peroxide, t-butyl cumyl peroxide, 2,5-dimethyl-2,5-di(t-butylperoxy) hexane, 2,5-dimethyl-2,5-di(t-butylperoxy)-3-hexyne and cumene hydroperoxide. The amount of the radical polymerization initiator is an effective amount, and typically is in the range of 0.01 to 20 parts by mass per 100 parts by mass of the acrylate or methacrylate.

The mixing ratio by mass of the (meth)acrylate monomer to the (meth)acrylated oligomer or polymer (which cures to an elastomer) is in the range of 2.5/97.5 to 10/90; in another embodiment the ratio is in the range of 2.5/97.5 to 30/70. In one embodiment the ratio is 2.5/97.5.

The curable composition according to the invention may contain tackifiers, adhesion promoters, thixotropic agents, plasticizers, antioxidants, ultraviolet light absorbers, softening agents, anti-foaming agents, pigments, dyes, organic fillers and perfumes, while still satisfying its properties.

To prepare any of the above laminating adhesive compositions, the components may be mixed at room temperature using conventional mixing means such as a stirring machine or a kneader. These compositions are coatable by various means known in the art for dispensing liquid adhesives and coatings onto a substrate, such as curtain coating, spray coating, roll coating, stencil printing or screen printing.

The curable composition may be cured by irradiation with electromagnetic energy rays, with application of heat during or after the curing, as required. The activation energy rays include corpuscular beams, electromagnetic waves, and combinations thereof. The corpuscular beams include electron beams (EB) and .alpha. rays. The electromagnetic waves include ultraviolet (UV) rays, visible rays, infrared rays, .gamma. rays and X rays. In one embodiment, electron beams (EB), visible wavelengths, and/or ultraviolet (UV) rays are used as the radiation source.

The activation energy rays may be radiated using a known apparatus. For the electron beams (EB), the accelerating voltage and the irradiation dose are suitably in the range of 0.1 to 10 MeV and 1 to 500 kGy, respectively. A 200-450 nm wavelength lamp can be suitably used as an ultraviolet (UV) radiation source. The electron beam (EB) sources include tungsten filaments, and the ultraviolet (UV) sources include low-pressure mercury lamps, high-pressure mercury lamps, ultrahigh-pressure mercury lamps, halogen lamps, excimer lamps, carbon arc lamps, xenon lamps, zirconium lamps, fluorescent lamps and sun's ultraviolet rays. The curable composition is generally irradiated with the activation energy rays for 0.5 to 300 seconds, although variable depending on the magnitude of the energy.

These curable laminating adhesive compositions show good rubber elasticity in a cured state and the additional properties of compatibility, transparency, waterproofness and flexibility, so that cracks and separation of cured products are reduced.

In some embodiments a getter material is associated with the cover. By associated is meant that a package containing a getter material can be attached to a cavity or indentation in the cover, or that the getter can be provided as a sheet of getter material or provided in grooves or channels in the cover. The getter can be any getter material that reacts readily with active gases (including water and oxygen) so as to render them harmless to the device. Desiccants, a class of getter material that removes water, are useful for the practice of the present invention.

Suitable getter materials include Group IIA metals and metal oxides, such as calcium metal (Ca), barium metal (Ba), calcium oxide (CaO) and barium oxide (BaO). Commerically available products include HICAP2000, a calcium oxide paste obtainable from Cookson SPM (Alpha Metals), CaO GDO getter packets from SAES Getters, and Q-Getter, a getter film obtainable from Frontech, Inc., Los Angeles, Calif., USA. Metal getter layers can also be applied to the cover using a number of vacuum deposition techniques such as thermal evaporation, sputtering, and electron-beam techniques.

The substrate and cover of the organic electronic device are selected to prevent or restrict transmission of oxygen and water from the outside environment to the active organic component. Depending on the application, the substrate and cover can be opaque or transparent. By "transparent" is meant that attenuation of radiation as it passes through the region of interest is low, with transmissivities typically greater than 50%, more typically greater than 80%, at the wavelength of interest.

The materials selected for the substrate and cover will depend upon the end use application, and include inorganic materials, metals including metal alloys, ceramics, polymers and composite layers. Inorganic materials such as silicon or glass offer good barrier properties to water, oxygen and other harmful species and also provide a substrate upon which electronic circuitry can be built. Metals also offer excellent barrier properties. Preferred materials include aluminum, stainless steel, gold, nickel, nickel alloys and indium, as well as other metals known in the art. Where flexibility is desired and transparency is not needed, metal foils can be used. Ceramics also offer low permeability, and they provide transparency as well in some cases. Polymers are often preferred where optical transparency is desired and flexibility is desired. Preferred low permeability polymers include polyesters, such as polyethylene terephthalate and polyethylenenapthalate, polyethersulfones, polyimides, polycarbonates and fluorocarbons, with such layers commonly being used in connection with composite substrates or covers. Such polymers may also be coated with inorganic and/or organic barrier coatings and/or various scratch resistant "hardcoats" as needed for a specific device geometry and application.

### EXAMPLES

Five formulations were prepared by mixing all the components using a speed-mixer at approximately 2000 rpm for 30 seconds to five minutes until a homogenous mixture was obtained. The formulations were degassed in a vacuum chamber to allow air bubbles to be released from the mixtures. Viscosity was measured using a Brookfield viscometer with a CP51 cone at 50°C and 1 rpm.

Adhesion was evaluated by a T-peel test according to the following protocol: formulation samples A through F were coated on a 100 µm acrylic coated PET (polyethylene terephthalate) substrate at room temperature using a hand-held draw-down coater; a second (non-acrylic coated) PET substrate was joined to the laminating adhesive and the two PET substrates laminated together using a lab laminator at room temperature. Formulation samples A through E (not being part of the present invention) were UV cured with 2.0 J/cm² of UV-A energy. Formulation F (according to the present invention) was cured at 100°C for one hour.

A comparative example using a pressure sensitive adhesive also was prepared (results shown in Figure 4). The pressure sensitive adhesive was a commercial solvent-borne product, DURO-TAK ® 87-608A from National Adhesives (ICI). The formulation was coated on a 100 µm acrylic coated PET (polyethylene terephthalate) substrate at room temperature using a hand-held draw-down coater followed by a solvent removal step using a conventional oven at 120°C for 30 minutes. A second (non-acrylic coated) PET substrate was joined to the laminating adhesive and the two PET substrates laminated together using a lab laminator at room temperature.

T-peel strength was recorded with an Instron 5543 using a peel rate of 305 mm/min. The selected geometry of T-peel samples was: Length=152 mm, Width=25.4 mm, adhesive thickness: 50 µm.

The compositions of the Formulation Samples in parts by weight, and the results of the viscosity measurements and adhesion strength tests are set out in Table 1. The adhesion strength tests show that the combination of the oligomer (and/or polymeric) material in combination with the reactive monome and initiator provides a laminating adhesive that has both good adhesion and good elastomeric properties to resist delamination. These compositions all exhibit good coatability at room temperature and good wet out of the 100% solids, liquid uncured adhesive.

Notes on Table 1:
1*. Supplied by Kuraray as product UC-203; Mw: 36000, methacrylate group: 3 units / chain
2.* Source: SR833S, product of Sartomer.
3*. Source: DAROCUR 1173, product of Ciba Speciality Chemical.
4* Source: SILQUESTA-1100, product of GE Silicones.
5.* Source: TRIGONOX 23, product of Akzo Nobel.
6*. Source: IRGANOX 1010, product of Ciba Speciality Chemical.

**TABLE 1: COMPOSITION (COMPONENTS IN PARTS BY WEIGHT) AND ADHESION**

| **Composition Component** | **Sample A**** | **Sample B**** | **Sample C**** | **Sample D**** | **Sample E **** | **Sample F** |
|---|---|---|---|---|---|---|
| 1.* liquid methacrylated polyisoprene | 100 | 97.5 | 95 | 90 | 70 | 97.5 |
| 2* tricyclodecane dimethanol diacrylate | 0 | 2.5 | 5 | 10 | 30 | 2.5 |
| 3.* 2-hydroxy-2-methyl-1-phenyl-1-propanone | 1 | 1 | 1 | 1 | 1 | |
| 4*. gamma-aminopropyltriethoxysilane | 1 | 1 | 1 | 1 | 1 | |
| 5*. thermal initiator tert-buyl peroxyneodecanoate | | | | | | 2 |
| 6.* antioxidant pentaerythrityl tetrakis [3-(3,5-di-tert-butyl-4-hydroxypheny)propionate] | | | | | | 0.3 |
| Viscosity (50°C, 1 rpm) (Pa.s) | 129 | 79 | 74 | 62 | 26 | 57 |
| Adhesion T-peel strength (N/25 mm) | 1.02 ± 0.13 | 6.81 ± 0.53 | 4.89 ± 0.27 | 3.83 ± 0.67 | 0.67 ± 0.18 | 5.25 ± 1.11 |

| | | | | | | |
|---|---|---|---|---|---|---|
| ** not being part of the present invention (no initiator present) | | | | | | |

In addition the comparative pressure sensitive sample and Sample 2 were prepared as described above in 60mm X 60mm squares. The laminating adhesive thickness is 50 µm. Both samples were held in 76.2 mm diameter chamber at 65°C for 20 hours, after which they were photographed. The results are shown here as Figures 4 and 5, and clearly show the superiority of the elastomeric laminating adhesive over the pressure sensitive adhesive in resisting creep and delamination.

Thus, this invention is an organic electronic evice according to claim 1.

In one embodiment, a barrier coating is disposed over the active organic component. In another embodiment the barrier coating is an inorganic barrier coating or a coating composed of a combination of inorganic and organic layers.

In a further embodiment, a getter is associated with the cover.

In the present invention the cured elastomeric laminating adhesive is prepared from a reactive liquid oligomer or polymer and a liquid monomer reactive with the liquid oligomer or polymer, and an initiator for either thermal and/or radiation cure.

In the present invention, the reactive liquid oligomer or polymer is selected from the group consisting of (meth)acrylated-polybutadienes, (meth)acrylated-polyisoprenes, (meth)acrylated-polyurethanes, and (meth)acrylated-polyesters, (meth)acrylated styrene-butadiene copolymer, (meth)acrylated acrylonitrile-butadiene copolymer, (meth)acrylated polyisobutylene, (meth)acrylated polysiloxanes, (meth)acrylated EPDM rubber (ethylene propylene diene copolymer), (meth)acrylated butyl rubber, (meth)acrylated bromobutyl rubber (bromoisobutylene-isoprene copolymer), (meth)acrylated chlorobutyl rubber (chloroisobutylene-isoprene copolymer), singly or in combination.

In the present invention, the reactive liquid oligomer or polymer is selected from the group consisting of (meth)acrylated-polybutadienes, (meth)acrylated-polyisoprenes, (meth)acrylated-polyurethanes, (meth)acrylated urethane oligomers, and (meth)acrylated-polyesters, singly or in combination.

In one embodiment, the liquid monomer reactive with the liquid oligomer or polymer is selected from the group consisting of butyl (meth)acrylate, cyclohexanedimethylol di(meth)acrylate, dicyclopentenyl (meth)acrylate, dicyclopentadienedimethylol di(meth)acrylate, 2-ethylhexyl (meth)acrylate, hexanediol di(meth)acrylate, 2-hydroxypropyl (meth)acrylate, isobornyl (meth)acrylate, isostearyl acrylate, morpholine (meth)acrylate, nonanediol di(meth)acrylate, phenoxyethyl acrylate, tricyclodecanedimethanol di(meth)acrylate, trimethylolpropane tri(meth)acrylate, tris(2-hydroxyethyl)isocyanurate tri(meth)acrylate, singly or in combination.

The laminating adhesive may be thermally curable or curable by actinic radiation.

This invention is a method for making an organic electronic device according to claim 4.

## Claims

1. An organic electronic device having a structure comprising
(a) a substrate;
(b) an active organic component disposed on the substrate;
(c) a cover;
(d) a cured elastomeric laminating adhesive disposed in the area between the substrate and the cover and enclosing the active organic component, wherein the elastomeric laminating adhesive comprises a reactive liquid oligomer and/or polymer and a liquid monomer reactive with the liquid oligomer and/or polymer and an initiator, and wherein the mixing ratio by mass of the monomer to the oligomer or polymer is in the range of 2.5/97.5 to 10/90,
in which the reactive liquid oligomers and/or polymers are selected from the group consisting of (meth)acrylated-polybutadienes, (meth)acrylated-polyisoprenes, (meth)acrylated-polyurethanes, (meth)acrylated urethane oligomers, (meth)acrylated-polyesters, (meth)acrylated styrene-butadiene copolymers, (meth)acrylated acrylonitrile-butadiene copolymer, (meth)acrylated polyisobutylene, (meth)acrylated polysiloxanes, (meth)acrylated (ethylene propylene diene copolymer), (meth)acrylated butyl rubber, (meth)acrylated bromoisobutylene-isoprene copolymer, (meth)acrylated chloroisobutylene-isoprene copolymer, and combinations thereof, and
in which the liquid monomer reactive with the liquid oligomer and/or polymer is selected from the group consisting of butyl (meth)acrylate, cyclohexanedimethylol di(meth)acrylate, dicyclopentenyl (meth)acrylate, dicyclopentadienedimethylol di(meth)acrylate, 2-ethylhexyl (meth)acrylate, hexanediol di(meth)acrylate, 2-hydroxypropyl (meth)acrylate, isobornyl (meth)acrylate, isostearyl acrylate, morpholine (meth)acrylate, nonanediol di(meth)acrylate, phenoxyethyl acrylate, tricyclodecanedimethanol di(meth)acrylate, trimethylolpropane tri(meth)acrylate, tris(2-hydroxyethyl)isocyanurate tri(meth)acrylate, and combinations thereof.

2. The organic electronic device according to claim 1 in which a barrier coating is disposed over the active organic component (b) and over part or all of the substrate (a).

3. The organic electronic device according to claim 1 or claim 2 in which a getter is associated with the cover (c).

4. A method of making an organic electronic device comprising
(a) providing a substrate;
(b) disposing an active organic component on the substrate;
(c) optionally placing a barrier coating over the active organic component and over part or all of the substrate;
(d) applying a liquid curable laminating adhesive that cures to become elastomeric to the area between the substrate and the cover, thereby enclosing the active organic component in the laminating adhesive;
(e) affixing a cover, which optionally contains getter material, over the laminating adhesive; and
(f) subjecting the laminating adhesive to heat or actinic radiation, thereby curing the laminating adhesive to form an elastomer;
wherein the elastomeric laminating adhesive comprises a reactive liquid oligomer and/or polymer and a liquid monomer reactive with the liquid oligomer and/or polymer and an initiator, and wherein the mixing ratio by mass of the monomer to the oligomer or polymer is in the range of 2.5/97.5 to 10/90,
in which the reactive liquid oligomers and/or polymers are selected from the group consisting of (meth)acrylated-polybutadieiies, (meth)acrylated-polyisoprenes, (meth)acrylated-polyurethanes, (meth)acrylated urethane oligomers, (meth)acrylated-polyesters, (meth)acrylated styrene-butadiene copolymers, (meth)acrylated acrylonitrile-butadiene copolymer, (meth)acrylated polyisobutylene, (meth)acrylated polysiloxanes, (meth)acrylated (ethylene propylene diene copolymer), (meth)acrylated butyl rubber, (meth)acrylated bromoisobutylene-isoprene copolymer, (meth)acrylated chloroisobutylene-isoprene copolymer, and combinations thereof, and
in which the liquid monomer reactive with the liquid oligomer and/or polymer is selected from the group consisting of butyl (meth)acrylate, cyclohexanedimethylol di(meth)acrylate, dicyclopentenyl (meth)acrylate, dicyclopentadienedimethylol di(meth)acrylate, 2-ethylhexyl (meth)acrylate, hexanediol di(meth)acrylate, 2-hydroxypropyl (meth)acrylate, isobornyl (meth)acrylate, isostearyl acrylate, morpholine (meth)acrylate, nonanediol di(meth)acrylate, phenoxyethyl acrylate, tricyclodecanedimethanol di(meth)acrylate, trimethylolpropane tri(meth)acrylate, tris(2-hydroxyethyl)isocyanurate tri(meth)acrylate, and combinations thereof.

5. The method according to claim 4 in which a barrier coating is disposed over the active organic component (b) and over part or all of the substrate (a).

6. The method according to claim 4 or claim 5 in which a getter is associated with the cover (c).

## Patentansprüche

1. Organische elektronische Vorrichtung mit einer Anordnung, Folgendes enthaltend:
(a) ein Substrat;
(b) einen auf dem Substrat angeordneten aktiven organischen Bestandteil;
(c) eine Abdeckung;
(d) einen wärmegehärteten elastomeren Kaschierklebstoff, in der Fläche zwischen dem Substrat und der Abdeckung angeordnet und den aktiven organischen Bestandteil umschließend, wobei der elastomere Kaschierklebstoff ein reaktives flüssiges Oligomer und/oder Polymer und ein mit dem flüssigen Oligomer und/oder Polymer reaktives flüssiges Monomer und einen Initiator umfasst und wobei das Mischungsverhältnis nach Masse des Monomers zu dem Oligomer oder Polymer im Bereich von 2,5/97,5 bis 10/90 liegt,
wobei die reaktiven flüssigen Oligomere und/oder Polymere ausgewählt sind aus der Gruppe bestehend aus (meth)acrylierten Polybutadienen, (meth)acrylierten Polyisoprenen, (meth)acrylierten Polyurethanen, (meth)acrylierten Urethanoligomeren, (meth)acrylierten Polyestern, (meth)acrylierten Styrol-Butadien-Copolymeren, (meth)acryliertem Acrylnitril-Butadien-Copolymer, (meth)acryliertem Polyisobutylen, (meth)acrylierten Polysiloxanen, (meth)acryliertem (Ethylen-Propylen-Dien-Copolymer), (meth)acryliertem Butylkautschuk, (meth)acryliertem Bromisobutylen-Isopren-Copolymer, (meth)acryliertem Chlorisobutylen-Isopren-Copolymer und Kombinationen daraus, und
wobei das mit dem flüssigen Oligomer und/oder Polymer reaktive flüssige Monomer ausgewählt ist aus der Gruppe bestehend aus Butyl(meth)acrylat, Cyclohexandimethylol-di(meth)acrylat, Dicyclopentenyl(meth)acrylat, Dicyclopentadiendimethylol-di(meth)acrylat, 2-Ethylhexyl(meth)acrylat, Hexandiol-di(meth)acrylat, 2-Hydroxypropyl(meth)acrylat, Isobornyl(meth)acrylat, Isostearylacrylat, Morpholin(meth)acrylat, Nonandiol-di(meth)acrylat, Phenoxyethyl-Acrylat, Tricyclodekandimethanol-di-(meth)acrylat, Trimethylolpropan-tri(meth)acrylat, Tris(2-hydroxyethyl)isocyanurat-tri(meth)acrylat und Kombinationen daraus.

2. Organische elektronische Vorrichtung nach Anspruch 1, wobei eine Barrierebeschichtung über dem aktiven organischen Bestandteil (b) und über einem Teil oder das gesamte Substrat (a) angeordnet ist.

3. Organische elektronische Vorrichtung nach Anspruch 1 oder 2, wobei ein Getter mit der Abdeckung (c) verbunden ist.

4. Verfahren zum Herstellen einer organischen elektronischen Vorrichtung, Folgendes umfassend:
(a) Bereitstellen eines Substrats;
(b) Anordnen eines aktiven organischen Bestandteils auf dem Substrat;
(c) optionales Platzieren einer Barrierebeschichtung über dem aktiven organischen Bestandteil und über einem Teil oder das gesamte Substrat;
(d) Auftragen eines flüssigen wärmehärtbaren Kaschierklebstoffs, der gehärtet wird, um elastomer zu werden, auf die Fläche zwischen dem Substrat und der Abdeckung, dadurch Umschließen des aktiven organischen Bestandteils in dem Kaschierklebstoff;
(e) Anbringen einer Abdeckung, die optional Gettermaterial enthält, über den Kaschierklebstoff; und
(f) Aussetzen des Kaschierklebstoffs Wärme- oder aktinischer Strahlung, dadurch Aushärten des Kaschierklebstoffs zum Ausbilden eines Elastomers;
wobei der elastomere Kaschierklebstoff ein reaktiv flüssiges Oligomer und/oder Polymer und ein mit dem flüssigen Oligomer und/oder Polymer reaktives flüssiges Monomer und einen Initiator umfasst, und wobei das Mischungsverhältnis nach Masse des Monomers zu dem Oligomer oder dem Polymer im Bereich von 2,5/97,5 bis 10/90 liegt,
wobei die reaktiven flüssigen Oligomere und/oder Polymere ausgewählt sind aus der Gruppe bestehend aus (meth)acrylierten Polybutadienen, (meth)acrylierten Polyisoprenen, (meth)acrylierten Polyurethanen, (meth)acrylierten Urethanoligomeren, (meth)acrylierten Polyestern, (meth)acrylierten Styrol-Butadien-Copolymeren, (meth)acryliertem Acrylnitril-Butadien-Copolymer, (meth)acryliertem Polyisobutylen, (meth)acrylierten Polysiloxanen, (meth)acryliertem (Ethylen-Propylen-Dien-Copolymer), (meth)acryliertem Butylkautschuk, (meth)acryliertem Bromisobutylen-Isopren-Copolymer, (meth)acryliertem Chlorisobutylen-Isopren-Copolymer und Kombinationen daraus, und
wobei das mit dem flüssigen Oligomer und/oder Polymer reaktive flüssige Monomer ausgewählt ist aus der Gruppe bestehend aus Butyl(meth)acrylat, Cyclohexandimethylol-di(meth)acrylat, Dicyclopentenyl(meth)acrylat, Dicyclopentadiendimethylol-di(meth)acrylat, 2-Ethylhexyl(meth)acrylat, Hexandiol-di(meth)acrylat, 2-Hydroxypropyl(meth)acrylat, Isobornyl(meth)acrylat, Isostearylacrylat, Morpholin(meth)acrylat, Nonandiol-di(meth)acrylat, Phenoxyethyl-Acrylat, Tricyclodekandimethanol-di-(meth)acrylat, Trimethylolpropan-tri(meth)acrylat, Tris(2-hydroxyethyl)isocyanurat-tri(meth)acrylat und Kombinationen daraus.

5. Verfahren nach Anspruch 4, wobei eine Barrierebeschichtung über dem aktiven organischen Bestandteil (b) und über einem Teil oder das gesamte Substrat (a) angeordnet wird.

6. Verfahren nach Anspruch 4 oder 5, wobei ein Getter mit der Abdeckung (c) verbunden ist.

## Revendications

1. Dispositif électronique organique ayant une structure comprenant
(a) un substrat ;
(b) un composant organique actif disposé sur le substrat ;
(c) un capot ;
(d) un adhésif de stratification élastomère durci disposé dans la zone située entre le substrat et le capot et renfermant le composé organique actif, l'adhésif de stratification élastomère comprenant un oligomère et/ou polymère liquide réactif et un monomère liquide réactif avec l'oligomère et/ou le polymère liquide et un initiateur, et le rapport de mélange en masse monomère sur oligomère ou polymère étant dans la gamme de 2,5/97,5 à 10/90,
dans lequel les oligomères et/ou polymères liquides réactifs sont choisis dans le groupe constitué par les polybutadiènes (méth)acrylés, polyisoprènes (méth)acrylés, polyuréthanes (méth)acrylés, oligomères d'uréthane (méth)acrylés, polyesters(méth)acrylés, copolymères styrène-butadiène(méth)acrylés, copolymère acrylonitrile-butadiène(méth)acrylés, polyisobutylène (méth)acrylés, polysiloxanes (méth)acrylés, (copolymère éthylène-propylène-diène) (méth)acrylé, caoutchouc butyle (méth)acrylé, copolymère bromoisobutylène-isoprène(méth)acrylé, copolymère chloroisobutylène-isoprène (méth)acrylés et leurs combinaisons, et
dans lequel le monomère liquide réactif avec l'oligomère et/ou polymère liquide est choisi dans le groupe constitué par le (méth)acrylate de butyle, le di(méth)acrylate de cyclohexanediméthylol, le di(méth)acrylate de dicyclopentenyle, le di(méth)acrylate de dicyclopentadiènediméthylol, le (méth)acrylate de 2-éthylhexyle, le di(méth)acrylate d'hexanediol, le di(méth)acrylate de 2-hydroxypropyle, le (méth)acrylate d'isobornyle, l'acrylate d'isostéaryle, le (méth)acrylate de morpholine, le di(méth)acrylate de nonanediol, l'acrylate de phénoxyéthyle, le di(méth)acrylate de tricyclodécanediméthanol, le tri(méth)acrylate de triméthylpropne, le tri(méth)acrylate de tris(2-hydroxyéthyl) isocyanurate, et leurs combinaisons.

2. Dispositif électronique organique selon la revendication 1, dans lequel un revêtement formant barrière est disposé sur le composant actif organique (b) et sur tout ou partie du substrat (a).

3. Dispositif électronique organique selon la revendication 1 ou la revendication 2, dans lequel un dégazeur est associé au capot (c).

4. Procédé de fabrication d'un dispositif électronique organique comprenant les opérations consistant à
(a) produire un substrat ;
(b) disposer d'un composant organique actif sur le substrat ;
(c) placer éventuellement un revêtement formant barrière sur le composant organique actif et sur une tout ou partie du substrat ;
(d) appliquer un adhésif de stratification durcissable liquide qui durcit pour devenir élastomère vis-à-vis de la zone située entre le substrat et le capot, ce qui enrobe le composant organique actif dans l'adhésif de stratification ;
(e) fixer un capot, qui contient éventuellement une matière de dégazage, sur l'adhésif de stratification ; et
(f) soumettre l'adhésif de stratification à de la chaleur ou un rayonnement actinique, ce qui durcit l'adhésif de stratification pour former un élastomère ;
l'adhésif de stratification élastomère comprenant un oligomère et/ou polymère liquide réactif et un monomère liquide réactif avec l'oligomère et/ou polymère liquide et un initiateur, et le rapport de mélange en masse monomère sur oligomère ou polymère étant dans la gamme de 2,5/97,5 à 10/90, dans lequel les oligomères et/ou polymères liquides réactifs sont choisis dans le groupe constitué par les polybutadiènes (méth)acrylés, polyisoprènes (méth)acrylés, polyuréthanes (méth)acrylés, oligomères d'uréthane (méth)acrylés, polyesters(méth)acrylés, copolymères styrène-butadiène(méth)acrylés, copolymère acrylonitrile-butadiène(méth)acrylés, polyisobutylène (méth)acrylés, polysiloxanes (méth)acrylés, (copolymère éthylène-propylène-diène) (méth)acrylé, caoutchouc butyle (méth)acrylé, copolymère bromoisobutylène-isoprène(méth)acrylé, copolymère chloroisobutylène-isoprène (méth)acrylés et leurs combinaisons, et
dans lequel le monomère liquide réactif avec l'oligomère et/ou polymère liquide est choisi dans le groupe constitué par le (méth)acrylate de butyle, le di(méth)acrylate de cyclohexanediméthylol, le di(méth)acrylate de dicyclopentenyle, le di(méth)acrylate de dicyclopentadiènediméthylol, le (méth)acrylate de 2-éthylhexyle, le di(méth)acrylate d'hexanediol, le di(méth)acrylate de 2-hydroxypropyle, le (méth)acrylate d'isobornyle, l'acrylate d'isostéaryle, le (méth)acrylate de morpholine, le di(méth)acrylate de nonanediol, l'acrylate de phénoxyéthyle, le di(méth)acrylate de tricyclodécanediméthanol, le tri(méth)acrylate de triméthylpropne, le tri(méth)acrylate de tris(2-hydroxyéthyl) isocyanurate, et leurs combinaisons.

5. Procédé selon la revendication 4, dans lequel un revêtement formant barrière est disposé sur le composant organique actif (b) et sur tout ou partie du substrat (a).

6. Procédé selon la revendication 4 ou la revendication 5 dans lequel un dégazeur est associé au capot (c).
